# EUROPEAN PATENT APPLICATION

(11) **EP 4 542 339 A1**
(43) Date of publication of application: **23.04.2025**
(21) Application number: 24205621.6
(22) Date of filing: 09.10.2024
(51) Int. Cl.: G06F 1/20, G06F 1/16, H05K 7/20, F28D 15/02

(54) **THERMAL CONNECTOR FOR BETTER ELECTRONICS COOLING**

(30) Priority: 19.10.2023 SG 10202302950T; 31.01.2024 GB 202401267
(71) Applicant: Harting International Innovation AG, 2504 Biel (CH)
(72) Inventor: Ng, Pei Sin, 120455 Singapore (SG)

(57) **Abstract**

Thermal connector (1) for conducting heat from a device generating heat (2) located in a housing (8) to a cooling module (3), the thermal connector (1) comprising a main body (4) including a support portion (5) and a heat transfer element (6) in contact with the support portion (5), wherein the main body (4) comprises a coupling interface (17) for being coupled in a removable way with the housing (8) of the device (2).

## Description

### TECHNICAL DOMAIN

The present invention relates to a thermal connector for conducting heat from a device generating heat located in a housing to a cooling module. Also, the present invention relates to a cooling apparatus comprising said thermal connector and a cooling module and to a system comprising said thermal connector or said cooling apparatus. In addition, the present invention relates to a method for transferring heat outside a housing of a device generating heat using said thermal connector or said cooling apparatus.

### RELATED ART

In the last decades, the use of computing devices is constantly increased, these being basically employed in any fields of technology, such as urban farms and video analytics applications. The performance of these devices and the amount of data to be processed increase despite a continuous request in reducing the dimensions.

The computing devices can be for example data center, edge Al, high performance computing, motor drive, edge Al computing comprising micro controller units (MCUs), graphic process units (GPUs) and Neural Process Units (NPUs).

One issue related to these devices is the production of heat. As a matter of fact, MCUs, GPUs, and NPUs generate a large amount of heat while computing a large amount of data. Existing heat management strategies comprise the dissipation of heat over a larger surface area. This heat dissipation usually occurs within the device enclosure and using heat pipes or vapor chambers to accelerate heat conduction so that heat is distributed faster to the rest of the device. Other forms of cooling systems employ heat sinks and fans to cool the chipset. However, heat sinks and cooling fans occupy space and increase the size of the product. Also, ventilation holes and gaps are necessary to cool the device through ventilation. Therefore, the housing of the device cannot be completely sealed, and dust and/or water particles can enter the housing thereby damaging the device.

Other types of cooling configurations are known from prior art. WO 2020/005175 A1 discloses for example a thermal connector for coupling a printed circuit board to a cooling structure such as a cold plate or a heat sink. This document refers to a permanent coupling, fasten by screw, to attach a thermal body used for absorbing heat from the device. However, the coupling arrangement is a bulky solution that is not flexible from the structural point of view in case of a replacement of components due to malfunctioning or damages.

### SHORT DICLOSURE OF INVENTION

Examples of the present disclosure seek to address or at least alleviate the above problems.

In a first aspect, there is provided a thermal connector for conducting heat from a device generating heat located in a housing to a cooling module, the thermal connector comprising:
a main body including a support portion and a heat transfer element in contact with the support portion,
wherein the main body comprises a coupling interface for being coupled in a removable way with the housing of the device.

In a second aspect, there is provided a cooling apparatus for transferring heat outside a housing of a device generating heat, the cooling apparatus comprising: a thermal connector according to the first aspect, and
a cooling module located outside the housing of the device, the cooling module being connected to the thermal connector through at least the heat transfer element of the thermal connector.

In a third aspect, there is provided a system comprising:
a thermal connector according to the first aspect, or a cooling apparatus according to the second aspect; and
a device generating heat, the device being located inside a housing and being connected to the thermal connector or the cooling apparatus through a heat collecting element,
wherein the heat collecting element comes into contact with the heat transfer element of the main body of the thermal connector, once the main body is coupled to the housing.

In a fourth aspect, there is provided a method for transferring heat outside a housing of a device generating heat using the thermal connector according to the first aspect or the cooling apparatus according to the second aspect or the system according to the third aspect, the method comprising coupling the main body to the housing, in particular to the receiving part of thermal connector. Other aspects and features are defined in the appended claims.

Examples of the disclosure may provide a connector to transfer heat from a device generating heat to a cooling element that is efficient and simple to realize. In particular, examples of the disclosure may provide a thermal connector between a heat generating device and a cooling system that can be easily installed and uninstalled in the field. Also, examples of the disclosure may provide a thermal connector for transferring heat outside the housing of a device, thereby maintaining said housing dust-free and waterproof.

### SHORT DESCRIPTION OF THE DRAWINGS

Examples of the disclosure will now be described by way of example only with reference to the accompanying drawings, in which like references refer to like parts, and in which:
- Figure 1: is a schematic representation of the thermal connector according to an example;
- Figure 2A: is a schematic representation of the thermal connector in uncoupled configuration according to an example;
- Figure 2B: is a schematic representation of the thermal connector in coupled configuration according to an example;
- Figure 3: is a schematic representation of the cooling apparatus and of the system according to an example;
- Figure 4A: is a side view of the thermal connector in uncoupled configuration according to an example;
- Figure 4B: is a side view of the thermal connector in coupled configuration according to an example;
- Figure 5A: is a top view of the thermal connector in uncoupled configuration according to an example; and
- Figure 5B: is a top view of the thermal connector in coupled configuration according to an example.

### EXAMPLES OF EMBODIMENTS OF THE PRESENT INVENTION

Some of the figures contain simplified, schematic representations. In some cases, identical reference signs are used for the same, but possibly not identical, elements. Different views of the same elements might be scaled differently. Directions such as "left", "right", "up" and "down" are to be understood in relation to the respective figure and may vary in the individual representations compared to the object depicted.

A thermal connector, a cooling apparatus, a system and a method for transferring heat outside a housing of a device generating heat are disclosed. In the following description, a number of specific details are presented in order to provide a thorough understanding of the examples of the disclosure. It will be apparent however to a person skilled in the art that these specific details need not be employed in order to practice the examples of the disclosure. Conversely, specific details known to the person skilled in the art are omitted for the purposes of clarity in presenting the examples.

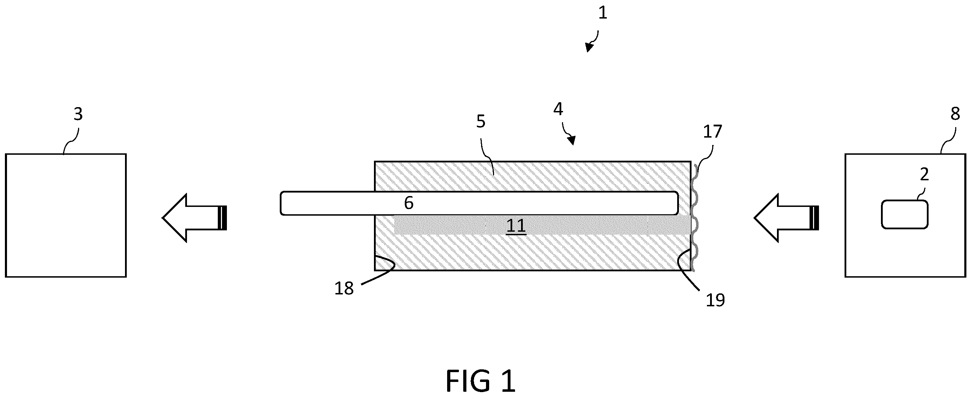

Figure 1 schematically illustrates a thermal connector 1 that is used to extract heat from a device 2 and to conduct extracted heat to a cooling module 3. It is noted that the device 2 is located inside a housing 8 or device enclosure and the cooling module 3 is located outside the housing 8. In other words, the thermal connector 1 is configured to provide heat passage from inside to outside the housing 8. The direction of the heat transfer is schematically illustrated with arrows in the figure. In a basic configuration, the thermal connector 1 comprises a main body 4, wherein said main body 4 includes a support portion 5 and a heat transfer element 6 in contact with the support portion 5. The main body 4 furthermore comprises a coupling interface 17 that is configured to be coupled in a removable way with the housing 8 of the device 2.

Advantageously, the thermal connector 1 can be attached to, and detached from, the housing 8 without big efforts. For example, the coupling interface 17 can be configured such that the coupling mechanism between the thermal connector 1 (or a component of the thermal connector 1) and the housing 8 occurs through an insertion/extraction mechanism, without the necessity of permanently fixing the thermal connector 1 to the housing 8, for example using screws or other fastening means. The thermal connector 1 (or a component of the thermal connector 1) can be a plug element that is insertable into the housing 8 for extracting heat from a device 2 located inside the housing 8. Therefore, the coupling interface 17 can comprise a plug-in junction, a snap-fit junction or another type of junction allowing a easy attachment to, and detachment from, the housing 8, without the need of fixing elements, like screws. For this purpose, the coupling interface 17 comprises coupling elements (not shown in the figure). In a simple configuration, the coupling interface comprises at least a protrusion that is insertable in the housing 8. Coupling elements can comprise pins, clips, clamps, or the like.

It is noted that the main body 4 of the thermal connector 1 can directly be coupled to the housing 8. Alternatively, as will be described later, the main body 4 can be indirectly coupled to the housing 8, i.e. using an interposed element that is fixable to the housing 8.

In one example, the coupling interface 17 is at least an external wall of the main body 4. The main body 4 can have a first wall 18, at one side of the main body 4, configured to be coupled to the cooling module 3 and a second wall 19, i.e. the outermost wall at the other side, that corresponds to the coupling interface 17. As shown in figure 1, the main body 4 can have an elongated shape, wherein one side of the elongate shaped body is the coupling interface 17.

The heat transfer element 6 serves to conduct heat through the main body 4 of the thermal connector 1, for example from the second wall 19 at the coupling interface 17 to the first wall 18 connectable to the cooling module 3. For this purpose, the heat transfer element 6 can be made of a material having high heat conductivity. For example, the heat transfer element 6 can comprise copper or aluminum. The heat transfer element 6 advantageously extends along the main body 4. The heat transfer element 6 can be entirely contained in the main body 1 of the thermal connector 1 or can extend outside the main body 4. Figure 1 shows an example wherein the heat transfer element 6 extends outside the main body 4 in the direction of the cooling module 3.

To favor the heat transfer, the heat transfer element 6 can comprise at least a heat pipe and/or a vapor chamber. For example, a heat pipe can extend along the main body 4 and be supported by the support portion 5. The heat transfer element 6 can also be configured as a cold or cooling plate with channels or pipes that meander or at least extend through the said plate.

In examples, the main body 4 comprises a recess region 11 extending along the heat transfer element 6. As shown in figure 1, the recess region 11 is located beneath the heat transfer element 6 and is configured to receive a corresponding element for collecting heat from the device 2, once the thermal connector is coupled to the housing 8 of the device 2. It is noted that the recess region 11 can alternatively be located above or sideways the heat transfer element 6, provided that a contact area is present between the heat transfer element 6 and the recess region 11.

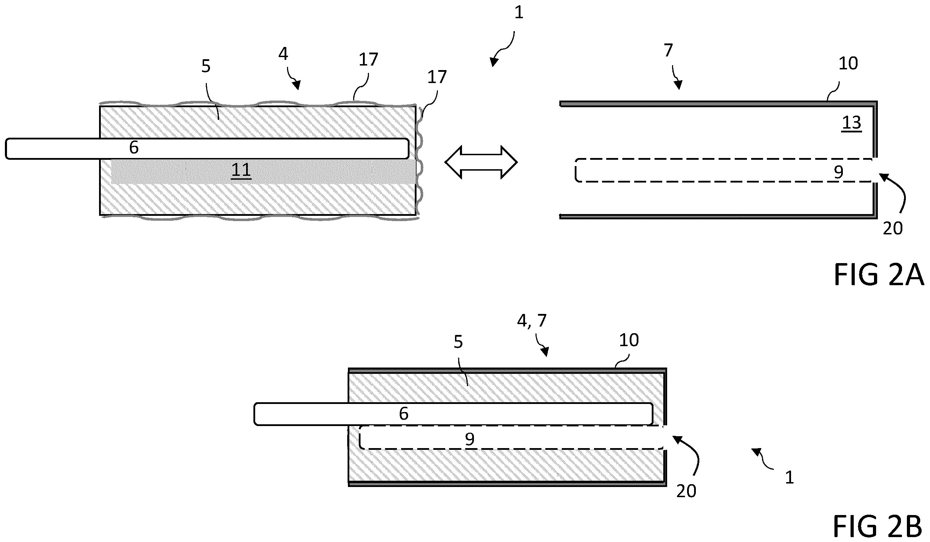

As already mentioned, the main body 4 can be indirectly coupled to the housing 8, i.e. using an interposed element that is fixable to the housing 8. This is shown in figures 2A and 2B.

According to this example, the thermal connector 1 further comprises a receiving part 7 fixable to, or fixed to, the housing 8 of the device 2, the receiving part 7 being physically separable from the main body 4 and comprising a case 10 having a heat transfer region 9. Figure 2A shows an uncoupled configuration wherein the main body 4 is separated from the receiving part 7 and figure 2B shows a coupled configuration, wherein the main body 4 is coupled to the receiving part 7.

In examples, the main body 4 can form a protrusion and the receiving part 7 can form a recess, the main body 4 being insertable into the receiving part 7. Figures 2A and 2B illustrate an example wherein the main body 4 can be completely inserted into the receiving part 7, i.e. into the case 10 of the receiving part 7. For example, the case 10 of the receiving part 7 can comprise a cavity 13 for completely receiving the main body 4 in particular the support portion 5, once the main body 4 is coupled to the housing 8, in particular to the receiving part 7. However, according to an alternative configuration, the main body 4 can be inserted only in part into the receiving part 7, i.e. into the cavity 13 of the receiving part 7.

In a configuration wherein the thermal connector 1 is coupled to the housing 8 of the device 2 using a receiving part 7 as shown in figures 2A and 2B, the coupling interface 17 serves to couple the main body 4 to the receiving part 7 and indirectly to the housing 8. Advantageously, the coupling interface 17 of the thermal connector 1 can extend along more than one external wall of the main body 4, e.g. the three walls that are in direct contact with the case 10 of the receiving part 7 (as simplified in figure 2A). According to other configurations, further coupling interface regions can be used in addition to the coupling interface 17 of the main body 4. For example, one or more walls of the cooling module 3 can be provided with coupling interfaces to improve the fastening between the thermal connector 1 and the housing 8, i.e. between the main body 4 and the receiving part 7.

In examples, the heat transfer region 9 of the receiving part 7 is configured to receive a heat collecting element 12 for collecting heat generated by the device 2, wherein the heat transfer element 6 of the main body 4 comes into contact with said heat collecting element 12, once the main body 4 is coupled to the housing 8, in particular to receiving part 7. For this purpose, the heat transfer region 9 can comprise a rear opening 20, through which a heat collecting element 12, for example a heat pipe, is inserted. Since the heat transfer region 9 overlaps the recess region 11 of the main body 4 once the main body 4 is coupled to receiving part 7, any element inserted into the rear opening 20, such as the heat collecting element 12, would touch the heat transfer element 6 of the thermal connector 1 in the coupling configuration.

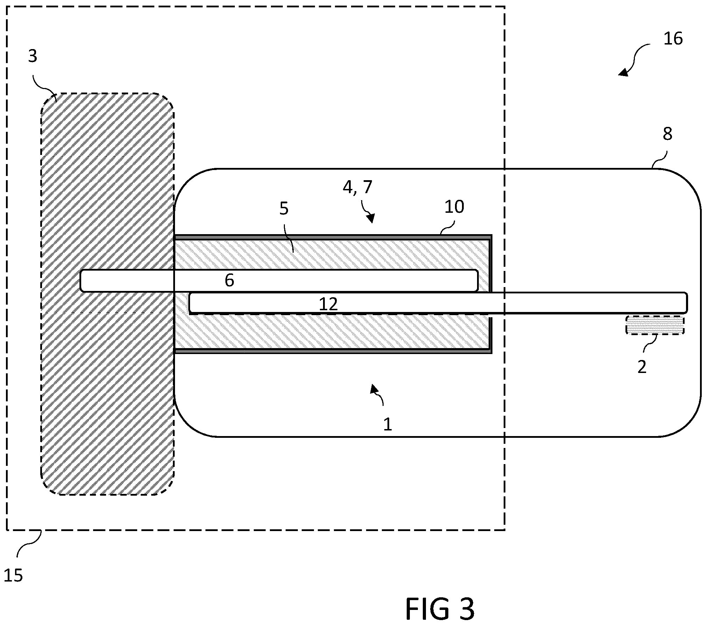

This is clearly shown in figure 3 that illustrates a system 16 comprising a thermal connector 1, a device generating heat 2 and a cooling module 3. In particular, the device 2 is located inside a housing 8 and is connected to the thermal connector 1 through a heat collecting element 12, for example a heat pipe. It is noted that once the thermal connector 1 is coupled to the housing 8 of the device 2, the heat collecting element 12 comes into contact with the heat transfer element 6 of the main body 4 of the thermal connector 1 to determine a heat passage from the device 2 outside the housing 8 through the thermal connector 1 and finally to the cooling module 3. From the figure 3 it is clear that in the coupling configuration at least one end of the heat transfer element 6 and of the heat collecting element 12 is completely enclosed in the case 10 of the receiving part 7 and/or in the housing 8. Whereas both ends of the heat collecting element 12 are inside the housing 8, one end of the heat transfer element 6 is located outside the housing 8 and is connected to the cooling module 3.

It is noted that the system 16 is designed such that the heat transfer element 6 and heat collecting element 12 can be mechanically disconnected in such a way that externally exerted pressure or movement on cooling module 3 or body 4 does not cause misalignment or delamination of heat collecting element 12 from the device 2 (i.e. heat source). In other words, external forces exerted on the cooling module 3 or on the main body 4 do not affect the connection between the heat collecting element 12 and the device 2. This is to avoid the cantilever effect causing poor connection between the heat collecting element 12 and the device 2.

Figure 3 shows a configuration, wherein the system 16 comprises a thermal connector 1 as illustrated in figures 2A-2B including a receiving part 7 that is inserted inside the housing 8 of the device 2. In this case, the thermal connector would have an external portion (i.e. main body 4) and an internal portion (i.e. the receiving part 7). However, this is only an illustrative example. As a matter of fact, the receiving part 7 can be inserted only in part into the housing 8 or can be located outside the housing 8, however with a contact surface between the case 10 and the housing 8.

In alternative, the system 16 can comprise a thermal connector 1 as shown in figure 1 without the receiving part 7, the thermal connector 1, i.e. the coupling interface 17 being directly in contact with the housing 8.

In examples, the device generating heat 2 is at least one of:
a. data center server;
b. edge AI device;
c. industrial computer;
d. high performance computing device;
e. motor drive; and/or
f. a programmable logic controller.

It is noted that the receiving part 7 of the thermal connector 1 can be insertable into the housing 8 of the device 2, meaning that the housing 8 is provided with a recess portion, inside which the receiving part 7 can be inserted, for example in a removable way. In alternative, the receiving part 7 is integrated into the housing 8 of the device 2, i.e. the receiving part 7 is an integral part of the housing.

Figure 3 also shows a cooling apparatus 15 for transferring heat outside a housing 8 of a device generating heat 2. The cooling apparatus 15 comprises a cooling module 3 that is located outside the housing 8 and a thermal connector 1 as described in figure 1 (i.e. without the receiving part 7) or a thermal connector 1 as described in figures 2A and 2B (i.e. with the receiving part 7).

In examples, the cooling module 3 comprises a passive cooling unit, in particular a heat sink with a heat pipe or a radiative cooling element. In alternative or in addition, the cooling module 3 is an active cooling unit, in particular a heat sink with a fan, a liquid cooling element, or a Peltier module.

As shown in figure 3, the cooling module 3 is connected to the thermal connector 1 through at least the heat transfer element 6 of the thermal connector 1 and the cooling module 3 is in touch with the heat transfer element 6. To increase the heat transfer, the heat transfer element 6 of the thermal connector 1 can extend at least in part inside the cooling module 3.

Advantageously, the cooling apparatus 15 can be attached to, and detached from, the housing 8 of the device 2 in a easy way, for example by simply plugging the cooling module 3, i.e. the main body 4 of the thermal connector 1, directly into the housing 8 or into the receiving part 7 that is fixable to the housing 8. This can be extremely useful in case the cooling module 15 needs to be replaced, due for example to a malfunctioning or a damage of the cooling module 3. In fact, the thermal connector 1 (or a part of the thermal connector 1) connected to the cooling module 3 can be detached from the housing 8, or from the receiving part 7, at the coupling interface 17 and another cooling apparatus 15, with a different o a repaired cooling module 3, can be attached to the housing 8, or to the receiving part 7.

In an additional advantage, the cooling apparatus 15 is designed to minimize and prevent external forces or pressures on the cooling module 3 or on main body 4 from dislodging the connection between the heat collecting element 12 and the device 2 (i.e. heat source).

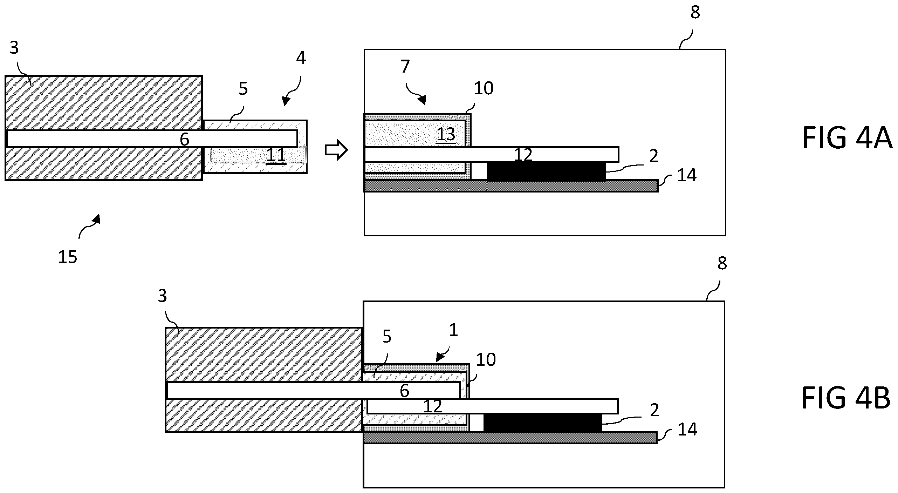

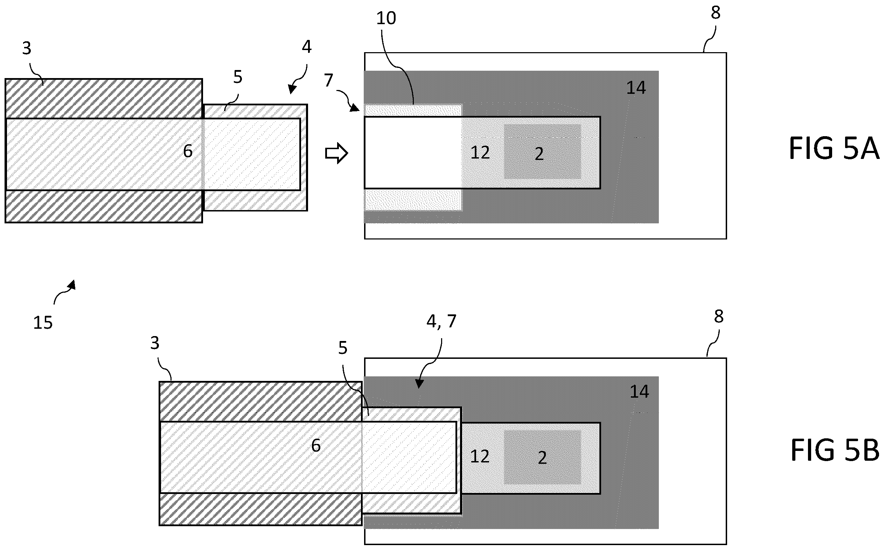

Figures 4A-4B and 5A-5B illustrate the attachment process of the thermal connector 1 or of the cooling apparatus 15 to the housing 8. In particular, figure 4A shows a lateral view of an uncoupled configuration, whereas figure 4B shows a lateral view of a coupled configuration. Figures 5A and 5B illustrate the same attachment process of figures 4A and 4B, wherein figure 5A shows a top view of an uncoupled configuration and figure 5B shows a top view of a coupled configuration.

The device 2 is located inside a housing 8 and positioned on a print circuit board 14. The device 2 generates heat and is in contact with a heat collecting element 12 to collect and transport heat away from the device 2. The heat collecting element 12 is an elongated element, for example a heat pipe, extending from the device 2 to the edge of the housing 8 passing through the case 10 of the receiving part 7 of the thermal connector 1. In a uncoupled configuration (figure 4A), the main body 4 of the thermal connector 1 and the cooling module 3 (forming here a cooling apparatus 15) is separated from the housing 8. In the coupled configuration (figure 4B), on the other hand, the thermal connector 1 or the cooling apparatus 15 is connected to the housing 8 and the main body 4 is inserted into the receiving part 7. In particular, the support portion 5 is inserted into the cavity 13 of the case 10 and the heat cooling element 12 is inserted into the recess region 11 of the main body 4 such that the heat transfer element 6 comes into contact with the heat cooling element 12. As long as the thermal connector 1 or cooling apparatus 15 is coupled to the housing 8, heat produced at the device 2 is conducted outside the housing 8 through the thermal connector 1 to the cooling module 3. In particular, the heat transfer element 6 is used to conduct heat through the main body 4 of the thermal connector 1, for example from the surface in contact with the heat collecting element 12, through heat transfer region 9, connectable to the cooling module 3.

Such type of thermal connector 1 is configured to cool the device 2 by transferring heat from the device 2 and PCB 14 to outside the housing 8. Heat can then be dissipated outside the housing 8 with a cooling module 3 such as heat sink, radiative cooling, heat convection, and other means.

Figures 5A and 5B show the same connection process in a top view. From these figures is clear that the contact between the heat collecting element 12 and the heat transfer element 6 occurs on a contact surface that should be wide enough to improve heat transfer. The area of the contact surface can be calculated as a function of heat transfer power; the larger the contact area, the higher the heat transfer.

The parts of the heat collecting element 12 and/or the heat transfer element 6 that engage and form the contact surface may be configured in any other shape, such as square, round, elliptical or a combination thereof, although they have been illustrated in a rectangular shape. This may apply to any other embodiment disclosed herein. In addition, and as mentioned before, the heat transfer element 6 can be configured as a cold plate. However, it is preferred to configure the heat transfer element 6 with a heat pipe or a vapor chamber.

By using the present thermal connector 1 and cooling apparatus 15 it is possible to dissipate heat outside the device's enclosure. This leads to a more effective cooling with external cooling solution, a simpler device's design (housing) since can be made smaller, an increased waterproofing of device due to a complete sealing, a more energy efficient cooling system that leverage cooler external ambient temperature outside the housing than the recirculating hot air inside the housing, a more dynamic cooling option when power is connected, and a longer electronics longevity with less thermal aging.

The present thermal connector 1, cooling apparatus 15 or system 16 can advantageously be used at least for data center servers, edge AI devices, industrial PC, high performance computing, and heat generating motors.

Although a variety of techniques and examples of such techniques have been described herein, these are provided by way of example only and many variations and modifications on such examples will be apparent to the skilled person and fall within the spirit and scope of the present invention, which is defined by the appended claims and their equivalents.

### REFERENCE SIGNS

- 1.: Thermal connector
- 2.: Device generating heat
- 3.: Cooling module
- 4.: First part
- 5.: Support portion
- 6.: Heat transfer element
- 7.: Second part
- 8.: Housing
- 9.: Heat transfer region
- 10.: Case
- 11.: Recess region
- 12.: Heat collecting element
- 13.: Cavity
- 14.: Printed circuit board
- 15.: Cooling apparatus
- 16.: System
- 17.: Coupling interface
- 18.: First wall
- 19.: Second wall
- 20.: Rear opening

## Claims

1. Thermal connector (1) for conducting heat from a device generating heat (2) located in a housing (8) to a cooling module (3), the thermal connector (1) comprising:
a main body (4) including a support portion (5) and a heat transfer element (6) in contact with the support portion (5),
wherein the main body (4) comprises a coupling interface (17) for being coupled in a removable way with the housing (8) of the device (2).

2. Thermal connector (1) according to claim 1, wherein the coupling interface (17) is at least an external wall of the main body (4).

3. Thermal connector (1) according to any one of claims 1 to 2, wherein:
a. the heat transfer element (6) is made of a material having high heat conductivity, in particular comprising copper or aluminum; and/or
b. the heat transfer element (6) comprises at least a heat pipe, a vapor chamber, and/or a cold plate.

4. Thermal connector (1) according to any one of claims 1 to 3, wherein the main body (4) comprises a recess region (11) extending along the heat transfer element (6).

5. Thermal connector (1) according to any one of claims 1 to 4, further comprising a receiving part (7) fixable to, or fixed to, the housing (8) of the device (2), the receiving part (7) being physically separable from the main body (4) and comprising a case (10) having a heat transfer region (9).

6. Thermal connector (1) according to claim 5, the main body (4) forms a protrusion and the receiving part (7) forms a recess, the main body (4) being insertable into the receiving part (7).

7. Thermal connector (1) according to any one of claims 5 to 6, wherein the case (10) of the receiving part (7) comprises a cavity (13) for completely receiving the main body (4) in particular the support portion (5), once the main body (4) is coupled to the housing (8), in particular to the receiving part (7).

8. Thermal connector (1) according to any one of claims 5 to 7, wherein the heat transfer region (9) of the receiving part (7) is configured to receive a heat collecting element (12) for collecting heat generated by the device (2) wherein the heat transfer element (6) of the main body (4) comes into contact with said heat collecting element (12), once the main body (4) is coupled to the housing (8), in particular to the receiving part (7).

9. Cooling apparatus (15) for transferring heat outside a housing (8) of a device generating heat (2), the cooling apparatus (15) comprising:
a thermal connector (1) according to any one of claims 1 to 4 or a thermal connector (1) according to any one of claims 5 to 8, and
a cooling module (3) located outside the housing (8) of the device (2), the cooling module (3) being connected to the thermal connector (1) through at least the heat transfer element (6) of the thermal connector (1).

10. Cooling apparatus (15) according to claim 9, wherein
a. the cooling module (3) comprises a passive cooling unit, in particular a heat sink with a heat pipe or a radiative cooling element, and/or
b. the cooling module (3) is an active cooling unit, in particular a heat sink with a fan, a liquid cooling element, or a Peltier module.

11. Cooling apparatus (15) according to any one of claims 9 to 10, wherein the heat transfer element (6) of the thermal connector (1) extends at least in part inside the cooling module (3).

12. System (16) comprising:
a thermal connector (1) according to any one of claims 1 to 8, or a cooling apparatus (15) according to any one of claims 9 to 11; and
a device generating heat (2), the device 2 being located inside a housing (8) and being connected to the thermal connector (1) or the cooling apparatus (15) through a heat collecting element (12),
wherein the heat collecting element (12) comes into contact with the heat transfer element (6) of the main body (4) of the thermal connector (1), once the main body (4) is coupled to the housing (8).

13. System (16) according to claim 12, wherein the device generating heat (2) is at least one of:
a. data center server;
b. edge AI device;
c. industrial computer;
d. high performance computing device;
e. motor drive; and/or
f. a programmable logic controller.

14. System (16) according to any one of claims 12 to 13, wherein the receiving part (7) of the thermal connector (1) is insertable or integrated into the housing (8) of the device (2).

15. Method for transferring heat outside a housing (8) of a device generating heat (2) using the thermal connector (1) according to any one of claims 1 to 8 or the cooling apparatus (15) according to any one of claims 9 to 11 or the system (16) according to any one of claims 12 to 14, the method comprising coupling the main body (4) to the housing (8), in particular to the receiving part (7) of thermal connector (1).
